Europäisches Patentamt

European Patent Office

Office européen des brevets

(11) Veröffentlichungsnummer: **0 143 146 B1**

(12) **EUROPÄISCHE PATENTSCHRIFT**

(45) Veröffentlichungstag der Patentschrift: 27.02.91

(51) Int. Cl.5: **H01J 37/256**, G01N 23/225

(21) Anmeldenummer: 84103386.3

(22) Anmeldetag: 27.03.84

(54) Verfahren und Vorrichtung zur Speicherung der Messdaten aus Teilbereichen eines Sputterkraters, der in einem Sekundärionen-Massenspektrometer erzeugt und analysiert wird.

(30) Priorität: 30.09.83 DE 3335625

(43) Veröffentlichungstag der Anmeldung:
05.06.85 Patentblatt 85/23

(45) Bekanntmachung des Hinweises auf die
Patenterteilung:
27.02.91 Patentblatt 91/09

(84) Benannte Vertragsstaaten:
AT DE FR GB NL

(56) Entgegenhaltungen:
DE-A- 2 023 688
US-A- 3 881 108

JOURNAL OF PHYSICS E; SCIENTIFIC IN-
STRUMENTS, Band 8, Nr. 10, Oktober 1975,
Seiten 797-808, London, GB; H. LIEBL: "Ion
probe microanalysis"

NUCLEAR INSTRUMENTS AND METHODS,
Band 149, Nr. 1/3, Februar/März 1978, Seiten
543-546, North-Holland Publishing Co., Amsterdam, NL; A.M. HUBER et al.: "Quantitative
analysis of oxygen in thin epitaxial layers of
GaAs by SIMS"

INTERNATIONAL JOURNAL OF MASS SPEC-
TROMETRY AND ION PHYSICS, Band 29, Nr.
4, April 1979, Seiten 351-361, Elsevier Scientific Publishing Company, Amsterdam, NL; F.
DEGREVE et al.: "Depth profiling by ion microprobe with high mass resolution"

MIKROCHIMICA ACTA, Nr. II, 1981, Seiten
375-379, Springer Verlag, Wien, AT; F.G. RÜ-
DENAUER et al.: "A further step towards
three-dimensional elemental analysis of solids"

(73) Patentinhaber: Siemens Aktiengesellschaft
Wittelsbacherplatz 2
D-8000 München 2(DE)

(72) Erfinder: von Criegern, Rolf, Dipl.-Phys.
Lilienstrasse 27
D-8192 Geretsried(DE)
Erfinder: Fazekas, Peter, Dipl.-Ing.
Stuntzstrasse 21
D-8000 München 80(DE)
Erfinder: Fottner, Johannes
Thalmannsdorf 3
D-8069 Jetzendorf(DE)

EP 0 143 146 B1

## Beschreibung

Verfahren zur Speicherung und Auswertung von Meßdaten eines Sekundärionen-Massenspektrometers

Die Erfindung betrifft ein Verfahren zur Speicherung und Auswertung von Meßdaten eines Sekundärionen-Massenspektrometers nach dem Oberbegriff des Patentanspruchs 1.

Ein solches Verfahren ist aus der Veröffentlichung von F. G. Rüdenauer et al in Mikrochimica Acta (Wien), 1981 II, S. 375-389 bekannt.

Bei der Analysentechnik der Sekundärionen-Massenspektrometrie (SIMS) wird ein Ionenstrahl zeilenweise über eine Probe abgelenkt und in dieser hierdurch ein Sputterkrater erzeugt. Die dabei entstehenden geladenen Abtragungsprodukte (Sekundärionen) werden einem Massenspektrometer zugeführt und analysiert. Durch Registrierung der Sekundärionen-Signalintensität einer bestimmten Ionenart in Abhängigkeit von der Zeit erhält man dabei ein sogenanntes Tiefenprofil für das betreffende chemische Element in der untersuchten Probe. Zur Sekundärionen-Signalintensität tragen bei einer integralen Messung die Sekundärionen aus dem gesamten Bereich des Sputterkraters bei. Üblicherweise wird allerdings die Messung mit Hilfe einer elektronischen Torschaltung ("gate") auf den mittleren Kraterbereich beschränkt, um Kraterrandeffekte zu vermeiden. Sollten im Verlauf einer Analyse innerhalb des Kraterbereiches Inhomogenitäten der Probe auftreten, so ist es beim integralen Verfahren nicht möglich, eine Unterscheidung der Sekundärionen-Signalbeiträge aus verschiedenartigen Teilbereichen zu treffen und die Inhomogenitäten zu eliminieren.

Aus der eingangs genannten Veröffentlichung von F.G. Rüdenauer ist bekannt, den Ionenstrahl eines Sekundärionen-Massenspektrometers mit Hilfe eines Rechners in kleinen Schritten punktweise über die Probe zu führen und die Sekundärionen-Signalbeiträge von jedem der abgetasteten Punkte abzuspeichern. Auf diese Weise kann man Auswertungen vornehmen, bei denen die Zuordnung der Meßwerte zu demjenigen Ort auf der Probe erhalten bleibt, von dem sie herrühren. Dieses Verfahren ist jedoch technisch aufwendig und kostspielig, da dessen Anwendung einen Prozeßrechner mit umfangreichem Massenspeicher in der Größenordnung von 100 MBytes erfordert. Außerdem muß eine Interface-Einheit zur Steuerung des Ionenstrahles durch den Rechner erstellt werden.

Der vorliegenden Erfindung liegt die Aufgabe zugrunde, ein Verfahren der eingangs genannten Art anzugeben, das erheblich einfacher und kostengünstiger ist als ein Verfahren zur vollständigen Datenspeicherung und welches einen wesentlichen Fortschritt gegenüber dem bekannten integralen Verfahren aufweist.

Diese Aufgabe wird erfindungsgemäß durch ein Verfahren nach Patentanspruch 1 gelöst.

Ausgestaltungen und Vorteile der Erfindung sind in den abhängigen Ansprüchen, der Beschreibung und der Zeichnung angegeben.

Erfindungsgemäß wird der vom Ionenstrahl eines Sekundärio nenspektrometers überstrichene Bereich einer Probe in eine Anzahl von Teilflächen unterteilt, beispielsweise in der Art eines Schachbrettes. Jeder Teilfläche des vom Ionenstrahl überstrichenen Bereiches der Probe wird ein Platz in einem Zwischenspeicher zugeordnet. Während nun der Ionenstrahl den gesamten Bereich des Sputterkraters einmal überstreicht, werden die aus den einzelnen Teilflächen des Sputterkraters kommenden Sekundärionen-Signalanteile jeweils zu einem Meßwert aufsummiert, im Zwischenspeicher geordnet abgelegt und nach Ende des Rasterdurchlaufes einem Rechner übermittelt. Der Meßwert-Satz eines solchen Rasterdurchlaufes repräsentiert ein Verteilungsbild der in der Probe vorhandenen chemischen Elemente. Durch eine Abfolge von Rasterdurchläufen entsteht eine Abfolge von derartigen Meßwert-Sätzen oder Element-Verteilungsbildern. Nach Ende einer Messung können die abgespeicherten Meßwerte auf verschiedene Weise ausgewertet werden.

Die Erfindung wird anhand der Zeichnungen näher erläutert.

Fig. 1 zeigt verschiedene Möglichkeiten der Auswertung der mit einem erfindungsgemäßen Verfahren gewonnenen Meßwerte.

Fig. 2 zeigt die erfindungsgemäße Aufteilung eines Sputterkraters in Teilflächen.

Fig. 3 zeigt eine Vorrichtung zur Durchführung des erfindungsgemäßen Verfahrens.

Bei der Analysentechnik der Sekundärionen-Massenspektrometrie (SIMS) wird die auf ihre elementare Zusammensetzung hin zu analysierende Probe mit einem Ionenstrahl (z. B. Sauerstoff $O_2^+$, 1 bis 15 keV, 1 nA bis 10 $\mu$A) beschossen und dadurch langsam in einem Sputter-Prozeß abgetragen. Die hierbei von der Probenoberfläche freigesetzten (abgesputterten) Atome und Molekülbruchstücke können, sofern sie elektrisch geladen sind ("Sekundärionen"), in ein Massen spektrometer gelenkt, hier nach ihrem Masse-Ladungs-Verhältnis $m/e$ getrennt und mit Hilfe eines Multipliers oder ähnlichem detektiert und gezählt werden.

Um eine gleichmäßige Abtragung der Proben über die zu analysierende Fläche zu erreichen, wird der Ionenstrahl üblicherweise auf die Probenoberfläche fokussiert und zeilenweise über die abzutragende Fläche abgelenkt. Als Raster-Ionenstrahlgerät kann beispielsweise ein Gerät a-DIDA der Fa. Atomika GmbH, München, Bundesrepublik Deutschland, verwendet werden.

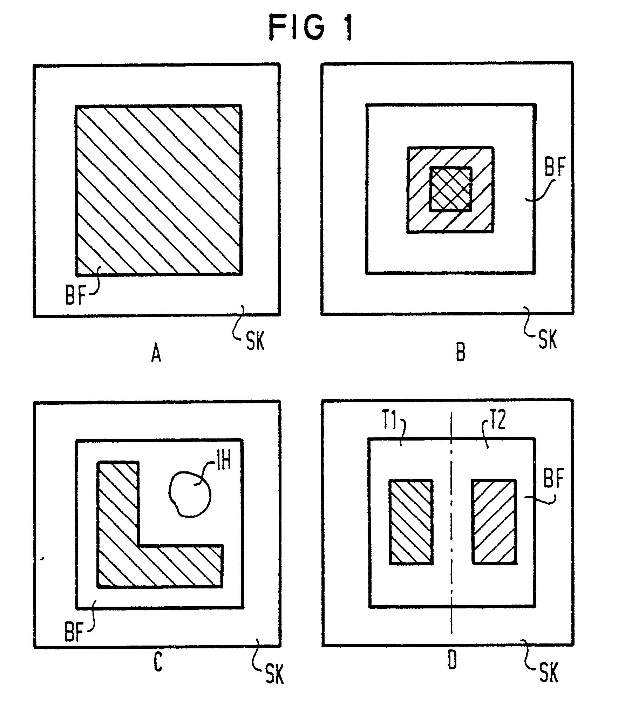

Fig. 1 zeigt einige Möglichkeiten der Auswertung der mit Hilfe des erfindungsgemäßen Verfahrens gewonnenen Meßwerte. Als Meßwert soll hierbei im folgenden eine Größe bezeichnet werden, die jeweils der Summe der Meßdaten aus einer der Teilflächen des Sputterkraters SK entspricht. Hat man zumindest einen inneren Bereich (Bildfläche BF) des Sputterkraters SK in der Art eines Schachbrettes beispielsweise in 8 x 8 = 64 als Teilflächen fungierende Felder aufgeteilt, so kann durch das Aufsummieren der zu einem einzigen Rasterdurchlauf gehörigen Meßwerte der 64 Teilflächen eine integrale Messung durchgeführt werden (siehe Fig. 1, Beispiel A).

Um eine integrale Messung mit unterschiedlicher Kraterrandausblendung durchzuführen, kann man jeweils die Meßwerte derjenigen Teilflächen zusammenfassen, die verschieden große konzentrische Bereiche des Sputterkraters SK überdecken (siehe Fig. 1, Beispiel B). Addiert man jeweils die Meßwerte sämtlicher Teilflächen innerhalb der konzentrischen Bereiche, so entsprechen die dabei erzielten Ergebnisse denjenigen integraler Messungen, bei denen variable elektronische "gate"-Bereiche den Kraterrand in jeweils verschiedenem Ausmaß ausblenden würden. Die Erfindung ermöglicht es, daß nur eine einzige Messung durchgeführt wird und daß erst nach Ende der Messung eine optimale Kraterrand ausblendung ermittelt wird. Die optimale Kraterrandausblendung ist dadurch definiert, daß einerseits möglichst kein Kraterrandeinfluß in den Meßdaten vorhanden ist und daß andererseits ein möglichst großer Bereich des Sputterkraters zum Meßergebnis beiträgt. Nach dem Stand der Technik konnte eine optimale Kraterrandausblendung erst dann angegeben werden, nachdem mehrere Wiederholungsmessungen mit unterschiedlicher Kraterrandausblendung durchgeführt worden waren.

Bei dem Beispiel C in Fig. 1 tritt innerhalb des Sputterkraters SK eine Inhomogenität IH auf. Das Auftreten einer Inhomogenität IH innerhalb des Sputterkraters SK kann durch Vergleich der Meßwerte verschiedener Teilflächen der Bildfläche BF festgestellt werden. Tritt im Verlauf einer Tiefenprofilmessung eine Inhomogenität IH innerhalb des Sputterkraters SK in Erscheinung, so können die Meßwerte jeweils gleichartiger Teilbereiche (im Beispiel C der Fig. 1 schraffiert dargestellt), zusammengefaßt werden, um auf diese Weise Tiefenprofile der verschiedenartigen Zonen des Sputterkraters SK zu gewinnen.

Das Beispiel D der Fig. 1 zeigt einen Spezialfall des Beispiels C der Fig. 1. Dabei ist eine Probe, z. B eine Halbleiterscheibe, in zwei aneinandergrenzenden Teilbereichen T1, T2 absichtlich unterschiedlich vorbehandelt worden. Um durch Vergleich die unter Umständen recht geringen Unterschiede in den verschiedenen Teilbereichen T1, T2 aufzuzeigen, soll je eine Tiefenprofilmessung auf jedem Teilbereich T1, T2 angefertigt werden.

Während bisher je eine Tiefenprofilmessung in zwei aneinandergrenzenden Teilbereichen T1, T2 nur durch zwei unabhängige Meßläufe möglich war, kann mit einem erfindungsgemäßen Verfahren über die Grenzlinie zwischen den beiden Teilbereichen T1, T2 hinweg gemessen werden, wobei diese Grenzlinie möglichst auch eine Grenzlinie zwischen verschiedenen Teilflächen des Sputterkraters SK sein soll. Nach Abschluß der Messung können bei einem erfindungsgemäßen Verfahren die Meßwerte aus den beiden unterschiedlichen Bereichen T1, T2 getrennt dargestellt werden. Eine mit einem erfindungsgemäßen Verfahren in dieser Weise durchgeführte Differenzmessung der unterschiedlichen Tiefenprofile in den Teilbereichen T1, T2 enthält weniger meßtechnische Toleranzen als zwei unabhängige, nacheinander ausgeführte Tiefenprofilmessungen nach dem Stand der Technik.

Solche Teilflächen, deren Meßwerte aufsummiert werden, sind in Fig.1 jeweils in gleicher Weise schraffiert dargestellt.

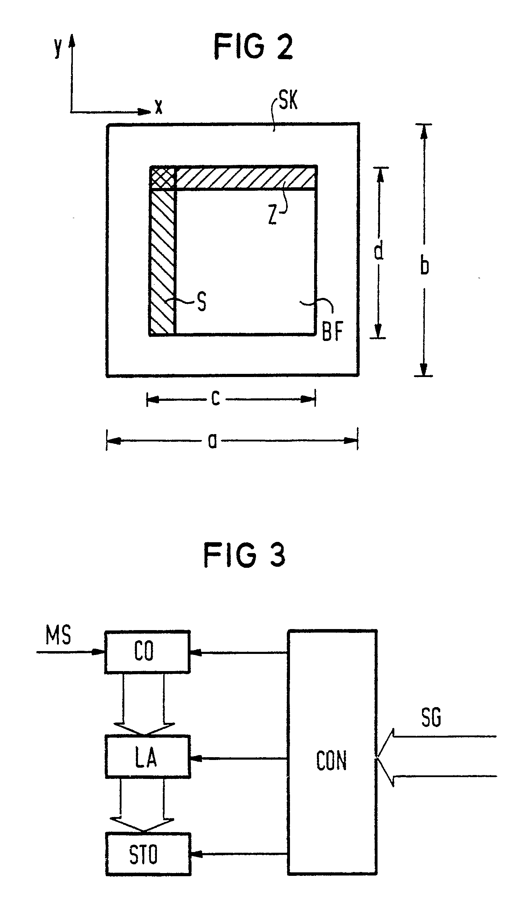

Fig.2 erläutert die Aufteilung eines Sputterkraters SK in Teilflächen nach der Erfindung. Die Fläche des Sputterkraters SK wird als Kraterfläche bezeichnet und hat eine Breite a und eine Länge b. Die Kraterfläche ist die vom Ionenstrahl bei einem Rasterdurchlauf auf der Probe überstrichene Fläche. Derjenige Teil der Kraterfläche, aus dem Meßdaten registriert und abgespeichert werden, wird als Bildfläche BF bezeichnet und hat in Fig.2 die Breite c und die Länge d. Bei dem genannten Sekundärionen-Massen spektrometer der Fa. Atomika wird der Ionenstrahl in 256 Zeilen mit Hilfe eines Raster-Generators über die Kraterfläche gelenkt. Eine Zeile ist dabei eine lineare Spur des Ionenstrahles auf der Probe bei Durchlauf in x-Richtung bei konstanter y-Koordinate. Die Bildfläche kann in eine Anzahl von Zeilenstreifen Z aufgeteilt werden. Dabei hat jeder Zeilenstreifen Z die Breite c und eine Länge, die einen Bruchteil der Länge d der Bildfläche beträgt. Die Bildfläche kann andererseits auch in Spaltenstreifen S aufgeteilt werden. Die Spaltenstreifen haben die gleiche Länge d wie die Bildfläche und ihre Breite beträgt einen Bruchteil der Breite c der Bildfläche. Bei dem im folgenden beschriebenen Ausführungsbeispiel soll die Bildfläche in n Spaltenstreifen S und m Zeilenstreifen Z aufgeteilt werden. Wird die Bildfläche kleiner als die Kraterfläche gewählt, so kann dabei durch Weglassen eines Randbereiches der Kraterfläche beim Abspeichern von Meßdaten Speicherplatz gespart werden.

Fig.3 erläutert eine Vorrichtung zur Speicherung der Meßdaten aus Teilbereichen eines Sputterkraters SK. Wird bei einem erfindungsgemäßen Verfahren beispielsweise eine Bildfläche mit acht Zeilenstreifen Z und acht Spaltenstreifen S, d.h. mit 8 mal 8 Bildsegmenten, zugrundegelegt, so läßt sich der Meßablauf folgendermaßen beschreiben: Die Zähleinheit CO besteht aus acht Zählern, die den acht Spaltenstreifen S auf der Bildfläche fest zugeordnet sind. Die Zähleinheit CO ist eine aus acht digitalen Zählern aufgebaute Einheit. Bei jedem Zeilendurchlauf des Ionenstrahles auf der Probe werden die acht Spaltenstreifen S der Bildfläche durchlaufen und jeder der acht Zähler der Zähleinheit CO beim Durchlaufen des jeweils zugeordneten Spaltenstrei fens S angesprochen. Die Umschaltung von einem Zähler zu einem anderen Zähler in der Zähleinheit CO geschieht durch Vergleich der Spaltennummern des Raster-Generators mit solchen Spaltennummern, die vor Durchführung des Versuches als Grenzspaltennummern zwischen jeweils zwei aneinandergrenzenden Spaltenstreifen S entsprechend der gewünschten Einteilung der Bildfläche in Spaltenstreifen S festgelegt worden sind. Ein solcher Vergleich der aktuellen Spaltennummern mit den vorgewählten Grenzspaltennummern an den Grenzen zwischen aneinandergrenzenden Spaltenstreifen S kann beispielsweise mittels Komparatoren erfolgen.

Jedes Bildsegment ist genau einem Zeilenstreifen Z und einem Spaltenstreifen S zugeordnet. Alle Teilergebnisse aus ein und demselben Bildsegment werden bei Abrastern eines Zeilenstreifens Z solange in demjenigen Zähler der Zähleinheit CO, der dem Spaltenstreifen S dieses Bildsegments zugeordnet ist, aufsummiert, bis der Ionenstrahl die Breite des entsprechenden Zeilenstreifens Z zum letzten Mal durchläuft. Während dieses letzten Zeilendurchlaufes innerhalb dieses Zeilenstreifens Z werden die jeweiligen aufsummierten Zählerinhalte, die in den jeweiligen Spaltenstreifen Z fest zugeordneten Zählern enthalten sind, in den Zwischenspeicher LA übernommen, sobald der Ionenstrahl das jeweilige Bildsegment innerhalb dieses Zeilenstreifens Z verläßt, und der entsprechende Zählerinhalt, der die Meßdaten aus diesem Bildsegment wiedergibt, wird in der Zähleinheit CO gelöscht. Bei den folgenden Zeilenstreifen Z wiederholt sich diese Abfolge des Meßablaufes.

Wenn die gesamte Bildfläche vom Ionenstrahl überstrichen worden ist, stehen somit die 64 Zählergebnisse von den 64 Bildsegmenten der in acht Spaltenstreifen S und acht Zeilenstreifen Z aufgeteilten Bildfläche im Zwischenspeicher LA zur Übernahme in den Rechner STO bereit.

Zur Erfassung der 64 Meßwerte aus den 64 Bildsegmenten sind erfindungsgemäß demnach nur acht Zähler erforderlich.

Zur Steuerung der Zählereinheit CO und des Zwischenspeichers LA in Abhängigkeit von der Position des Ionenstrahles ist eine zentrale Steuerung CON erforderlich. Diese zentrale Steuerung CON erhält vom Raster-Generator ein Signal SG, das die Zeilennummer und die Spaltennummer der jeweiligen Position des Ionenstrahles auf dem Sputterkrater SK enthält. In Abhängigkeit von diesem Signal SG erhält die Zähleinheit CO ein Signal von der zentralen Steuerung CON, von welchem Zähler das jeweilige Signal MS vom Massenspektrometer erfaßt werden soll. Bei Beendigung der Abrasterung des jeweiligen Bildelementes veranlaßt die zentrale Steuerung CON die Übernahme des entsprechenden Zählerinhaltes aus der Zähleinheit CO auf den entsprechenden Speicherplatz im Zwischenspeicher LA, sodann das Löschen dieses in den Zwischenspeicher LA übernommenen Zählerinhaltes in der Zähleinheit CO, und steuert schließlich die Übernahme der im Zwischenspeicher LA enthaltenen Zählergebnisse in den Rechner STO.

Die Zeilenstreifen Z und Spaltenstreifen S müssen nicht eine einheitliche und gemeinsame Breite bzw. Länge haben.

Die Bildfläche muß nicht mit der Kraterfläche deckungsgleich sein. Zur Reduzierung von Kraterrandeinflüssen kann am Rand der Kraterfläche ein Rahmen von einigen Zeilen und Spalten vorgesehen werden, in dem zwar die Probe abgesputtert wird, von dem jedoch keine Signale MS aufgezeichnet werden, um den Speicherbedarf klein zu halten.

## Ansprüche

1. Verfahren zur Speicherung und Auswertung von Meßdaten eines Sekundärionen-Massenspektrometers, die von Sekundärionen herrühren, die ein Primärionenstrahl beim Abtasten der Oberfläche einer Probe unter Bildung eines Sputterkraters (SK) erzeugt, bei dem eine Bildfläche (BF), die zumindest ein Teil des Sputterkraters ist, in eine Mehrzahl nicht überlappender Teilflächen unterteilt wird, aus derselben Teilfläche stammende Meßdaten jeweils zu einem einzigen Meßwert für die betreffende Teilfläche zusammengefaßt werden und jeder dieser Meßwerte an einem der betreffenden Teilflächen zugeordneten Speicherplatz abgelegt wird,

   **dadurch gekennzeichnet,** daß die Meßdaten zu den Meßwerten aufsummiert werden, während der Primärionenstrahl die betreffenden Teilflächen abtastet, und daß die bei einunddemselben Abtastdurchgang gewonnenen Meßwerte mehrerer ausgewählter Teilflächen ihrerseits zu mindestens einem einen Bildflächenbereich repräsentierenden, integralen Meßwert aufsummiert werden.

2. Verfahren nach Anspruch 1, **dadurch gekennzeichnet**, daß die Bildfläche (BF) in einer ersten Richtung (x) in eine erste Anzahl (m) streifenförmiger Bereiche (Z) unterteilt wird, daß die Bildfläche (BF) in einer zweiten Richtung (y) in eine zweite Anzahl (n) streifenförmiger Bereiche (S) unterteilt wird und daß die gemeinsame Fläche zweier streifenförmiger Bereiche (Z, S) jeweils eine Teilfläche definiert.

3. Verfahren nach Anspruch 2, **dadurch gekennzeichnet**, daß die erste und die zweite Richtung (x, y) einen Winkel von 90˚ einschließen.

4. Verfahren nach einem der Ansprüche 1 bis 3, **dadurch gekennzeichnet**, daß die Meßwerte zunächst zwischengespeichert (LA) und nach jedem Abtastdurchgang in eine weitere Speichereinheit (STO) eingelesen werden.

5. Verfahren nach einem der Ansprüche 1 bis 4, **dadurch gekennzeichnet**, daß die Bildfläche (BF) mehrmals abgetastet wird und daß die Meßwerte als Funktion der einzelnen Abtastungen gespeichert werden.

6. Verfahren nach einem der Ansprüche 1 bis 5, **dadurch gekennzeichnet**, daß die Meßwerte zu einem integralen Meßwert für die gesamte Bildfläche (BF) aufsummiert werden.

7. Verfahren nach einem der Ansprüche 1 bis 5, **dadurch gekennzeichnet**, daß die Meßwerte zu integralen Meßwerten für jeweils unterschiedlich große konzentrische Oberflächenteile des Sputterkraters (SK) aufsummiert werden.

8. Verfahren nach einem der Ansprüche 1 bis 5, **dadurch gekennzeichnet,** daß die Meßwerte zu einem integralen Meßwert für einen Oberflächenteil des Sputterkraters aufsummiert werden, in dem eine Inhomogenität (IH) vorhanden ist.

9. Verfahren nach einem der Ansprüche 1 bis 5, **dadurch gekennzeichnet**, daß die Meßwerte zu einem integralen Meßwert für einen Oberflächenteil des Sputterkraters aufsummiert werden, in dem keine Inhomogenität (IH) vorhanden ist.

10. Verfahren nach Anspruch 5, **dadurch gekennzeichnet,** daß eine Probe in einem ersten und einem zweiten Bereich (T1, T2) unterschiedlich vorbehandelt wird und daß die Meßwerte aus diesen aneinandergrenzenden Bereichen (T1, T2) getrennt ausgewertet werden, um die jeweiligen Tiefenprofile zu erhalten.

## Claims

1. Method for storing and evaluating measurement data of a secondary-ion mass spectrometer, which originate from secondary ions generated by a primary-ion beam during the scanning of the surface of a specimen with the formation of a sputter crater (SK), in which an image region (BF), which is at least a part of the sputter crater, is subdivided into a plurality of non-overlapping sub-regions, measurement data originating from the same sub-region are in each case combined to form a single measurement value for the sub-region concerned and each of these measurement values is stored at a storage location associated with one of the sub-regions concerned, characterised in that the measurement data are summed together to form the measurement values during the time when the primary-ion beam scans the sub-regions concerned, and in that the measurement values of several selected sub-regions, obtained during one and the same scanning pass, in turn are summed together to form at least one integral measurement value representing an image region area.

2. Method according to Claim 1, characterised in that the image region (BF) is subdivided into a first number (m) of strip-shaped areas (Z) in a first direction (X), in that the image region (BF) is subdivided into a second number (n) of strip-shaped areas (S) in a second direction (y), and in that the common region of two strip-shaped areas (Z, S) in each case defines a sub-region.

3. Method according to Claim 2, characterised in that the first and the second direction (x, y) enclose an angle of 90˚.

4. Method according to one of Claims 1 to 3, characterised in that the measurement values are first temporarily stored (LA) and are entered into a further storage unit (STO) after each scanning pass.

5. Method according to one of Claims 1 to 4, characterised in that the image region (BF) is scanned several times and in that the measurement values are stored as a function of the individual scans.

6. Method according to one of Claims 1 to 5, characterised in that the measurement values are summed together to form an integral measurement value for the entire image region (BF).

7. Method according to one of Claims 1 to 5, characterised in that the measurement values are summed together to form integral measurement values for in each case differently sized concentric surface sections of the sputter crater (SK).

8. Method according to one of Claims 1 to 5, characterised in that the measurement values are summed together to form an integral measurement value for a surface section of the sputter crater in which an inhomogeneity (IH) exists.

9. Method according to one of Claims 1 to 5, characterised in that the measurement values are summed together to form an integral measurement value for a surface section of the sputter crater in which no inhomogeneity (IH) exists.

10. Method according to Claim 5, characterised in that a specimen is differently pretreated in a first and a second area (T1, T2) and in that the measurement values from these adjoining areas (T1, T2) are separately evaluated in order to obtain the respective depth profiles.

**Revendications**

1. Procédé de mémorisation et d'exploitation des données de mesure d'un spectromètre de masse à ions secondaires, qui proviennent des ions secondaires d'un faisceau d'ions primaires produits lors du balayage de la surface d'un échantillon avec formation d'un cratère de pulvérisation cathodique (SK), dans lequel une surface d'image (BF), qui est au moins une partie du cratère de pulvérisation cathodique, est subdivisée en un grand nombre de surfaces partielles qui ne se recouvrent pas, les données de mesure issues de la même surface partielle étant rassemblées en une valeur de mesure unique pour la surface partielle concernée et chacune de ces valeurs de mesure étant archivée en un emplacement de mémoire associé à la surface partielle concernée,

caractérisé en ce qu'il consiste à sommer les données de mesure en les valeurs de mesure pendant que le faisceau ionique primaire balaye les surfaces partielles concernées et à sommer, de leur côté, les valeurs de mesure de plusieurs surfaces partielles choisies, qui ont été obtenues par un seul et même passage de balayage, en au moins une valeur de mesure intégrale représentant un domaine de la surface d'image.

2. Procédé suivant la revendication 1, caractérisé en ce qu'il consiste à subdiviser la surface d'image (BF) dans une première direction (x) en un premier nombre (m) de domaines (Z) en forme de bande, à subdiviser la surface d'image (BF) dans une seconde direction (y) en un second nombre (n) de domaines (S) en forme de bande, et à définir une surface partielle par les surfaces totales de deux domaines (Z, S) en forme de bande.

3. Procédé suivant la revendication 2, caractérisé en ce que la première et la seconde direction (x, y) font un angle de 90°.

4. Procédé suivant l'une des revendications 1 à 3, caractérisé en ce qu'il consiste à mémoriser d'abord intermédiairement (LA) les valeurs de mesure et à les introduire après chaque passage de balayage dans une autre unité de mémorisation (STO).

5. Procédé suivant l'une des revendications 1 à 4, caractérisé en ce qu'il consiste à balayer la surface d'image (BF) plusieurs fois et à mémoriser les valeurs de mesure en fonction des balayages individuels.

6. Procédé suivant l'une des revendications 1 à 5, caractérisé en ce qu'il consiste à sommer les valeurs de mesure en une valeur de mesure intégrale pour toute la surface d'image (BF).

7. Procédé suivant l'une des revendications 1 à 5, caractérisé en ce qu'il consiste à sommer les valeurs de mesure en des valeurs de mesure intégrales pour chaque partie de surface concentrique de dimension différente du cratère de pulvérisation cathodique (SK).

8. Procédé suivant l'une des revendications 1 à 5, caractérisé en ce qu'il consiste à sommer les valeurs de mesure en une valeur de mesure intégrale pour une partie de la surface du cratère de pulvérisation cathodique dans lequel se présente une hétérogénéité (IH).

9. Procédé suivant l'une des revendications 1 à 5, caractérisé en ce qu'il consiste à sommer les valeurs de mesure en une valeur de mesure intégrale pour une partie de la surface du cratère de pulvérisation cathodique qui ne présente pas d'hétérogénéité (IH).

10. Procédé suivant la revendication 5, caractérisé en ce qu'il consiste à prétraiter, de manière différente, un échantillon dans un premier domaine (T1) et dans un second domaine (T2) et à exploiter séparément les valeurs de mesure provenant de ces domaines (T1, T2) adjacents, pour obtenir les profils de concentration suivant la profondeur.

# FIG 1

# FIG 2

# FIG 3